(19) Europäisches Patentamt / European Patent Office / Office européen des brevets

(11) EP 3 256 910 B1

(12) FASCICULE DE BREVET EUROPEEN

(45) Date de publication et mention de la délivrance du brevet:
**31.10.2018 Bulletin 2018/44**

(21) Numéro de dépôt: **16709989.4**

(22) Date de dépôt: **12.02.2016**

(51) Int Cl.:
*G04B 17/06* *(2006.01)*    *G04B 17/22* *(2006.01)*
*B81B 3/00* *(2006.01)*

(86) Numéro de dépôt international:
**PCT/FR2016/050333**

(87) Numéro de publication internationale:
**WO 2016/128694 (18.08.2016 Gazette 2016/33)**

(54) **OSCILLATEUR MÉCANIQUE ET PROCÉDÉ DE RÉALISATION ASSOCIE**

MECHANISCHER OSZILLATOR UND ZUGEHÖRIGES HERSTELLUNGSVERFAHREN

MECHANICAL OSCILLATOR AND ASSOCIATED PRODUCTION METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.02.2015 FR 1551233**

(43) Date de publication de la demande:
**20.12.2017 Bulletin 2017/51**

(73) Titulaire: **Tronic's Microsystems**
**38920 Crolles (FR)**

(72) Inventeurs:
• **GAFF, Vincent**
**38320 Brie (FR)**
• **VISSE, Pierre-Marie**
**38100 Grenoble (FR)**
• **RIBETTO, Luca**
**38500 Voiron (FR)**

(74) Mandataire: **Cabinet Laurent & Charras**
**Le Contemporain**
**50 Chemin de la Bruyère**
**69574 Dardilly Cedex (FR)**

(56) Documents cités:
EP-A1- 1 791 039    WO-A2-2015/011637
CH-A2- 701 605    CH-B1- 708 067

**Description**

DOMAINE TECHNIQUE

L'invention concerne le domaine des oscillateurs mécaniques ainsi qu'un procédé de réalisation d'un oscillateur mécanique. L'invention trouve une application particulièrement avantageuse pour les ressorts spiraux destinés à équiper le balancier d'un ensemble d'horlogerie mécanique telle qu'une montre.

ART ANTERIEUR

Un oscillateur mécanique est un dispositif permettant d'entretenir le mouvement d'une masse par rapport à un point stable sous l'effet d'une force. La force instantanée appliquée par l'oscillateur mécanique sur la masse dépend de plusieurs paramètres dont la raideur du matériau constituant l'oscillateur mécanique. L'oscillateur mécanique est classiquement constitué par un barreau qui peut adopter des formes très variées telles qu'un segment droit, un hélicoïde ou une spirale.

Certaines applications de précision, telles que les ressorts spiraux destinés à équiper le balancier d'un ensemble d'horlogerie mécanique, nécessitent un barreau sous la forme d'une spirale dont la raideur varie le moins possible en fonction de la température. La raideur d'un ressort de type spiral est donnée par :

$$K = \frac{M}{\varphi}$$

avec :

$\varphi$, l'angle de torsion du ressort et
$M$, le couple de rappel du ressort spiral.

L'équation de ce couple de rappel pour un barreau constitué d'un matériau spécifique est donné par :

$$M = \frac{E}{L\left(\frac{w^3 t}{12}\varphi\right)}$$

avec :

$E$, le module d'Young du matériau employé pour le barreau,
$L$, la longueur du barreau,
$w$, la largeur du barreau, et
$t$, l'épaisseur du barreau.

La fréquence propre de résonance du spiral est proportionnelle à la racine carrée de sa raideur. Par conséquent, la fréquence du spiral est proportionnelle à la racine carré du module d'Young du matériau du barreau. Donc, si le module d'Young varie en fonction de la température, la fréquence du spiral va également varier en fonction de la température. Pour une faible variation en température, la fréquence du spiral dépend donc au premier ordre de la variation en température du module d'Young. Il est ainsi admis que l'équation suivante montre les variations du module d'Young en fonction de la température :

$$E = E_0\left(1 + \propto_E (T - T_0)\right)$$

avec :

$\propto_E$, le coefficient thermique du module d'Young,
$E$, le module d'Young à la température $T$, et
$E_0$, le module d'Young à la température $T_0$.

Il est connu de fabriquer des oscillateurs mécaniques en utilisant des alliages complexes, tant par le nombre des composants (fer, carbone, nickel, chrome, tungstène, molybdène, béryllium, niobium...) que par les procédés métallurgiques utilisés pour obtenir une auto compensation des variations du module d'élasticité du métal en combinant deux influences contraires: celle de la température et celle de la magnéto constriction (contraction des corps magnétiques sous l'effet de l'aimantation). Cependant, ces oscillateurs métalliques sont difficiles à fabriquer. Tout d'abord, en raison de la complexité des procédés utilisés pour réaliser les alliages, les propriétés mécaniques intrinsèques du métal ne sont pas constantes d'une production à l'autre. Ensuite, le réglage, qui est la technique permettant de faire en sorte que l'oscillateur soit régulier, est fastidieux et long. Cette opération nécessite de nombreuses interventions manuelles et beaucoup de pièces défectueuses doivent être éliminées. Pour ces raisons, la production est coûteuse et le maintien d'une qualité constante est un défi permanent.

Il est également connu de réaliser des oscillateurs mécaniques par gravure d'une galette de silicium afin d'améliorer la régularité et la précision de conception. Les procédés de réalisation de ces oscillateurs mécaniques utilisent généralement des galettes de silicium monocristallin. Ainsi, ces oscillateurs mécaniques présentent une direction cristallographique prédéterminée par rapport à la galette de silicium utilisée, par exemple l'ensemble de directions <100>. Cependant, le module d'Young pour le silicium monocristallin n'est pas identique dans toutes les directions du matériau et cela induit une différence de comportement mécanique en fonction de l'axe du mouvement.

La demande de brevet suisse N° 699 780 présente un oscillateur mécanique de type spiral réalisé à partir d'une galette de silicium monocristallin. Les variations en température du module d'Young du barreau en forme de spiral sont compensées par deux couches métalliques amorphes disposées à l'intérieur du barreau de silicium et dont le coefficient thermique du module d'Young est opposé à celui du silicium. Ce document ne permet pas de compenser les variations en température du module d'Young de la même manière dans plusieurs directions du plan de la galette de silicium monocristallin.

Les brevets européens N° 1 422 436 et N° 2 215 531 présentent également un oscillateur mécanique de type spiral réalisé à partir d'une galette de silicium monocristallin. Les variations en température du module d'Young sont compensées par une couche d'oxyde de silicium amorphe disposée autour d'un barreau de silicium. Le coefficient thermique du module d'Young pour le silicium est de $-64.10^{-6}K^{1}$ et le coefficient thermique du module d'Young pour l'oxyde de silicium est de $187,5.10^{-6}K^{-1}$ à une température ambiante, environ 20°C.

Le brevet européen N° 1 422 436 propose de compenser les variations du module d'Young du barreau en silicium dans plusieurs directions d'un plan à l'aide d'une modulation de la largeur du barreau en fonction des sollicitations attendues par le barreau. Cette solution est particulièrement complexe à mettre en oeuvre car elle nécessite de connaitre toutes les sollicitations attendues sur le barreau et d'adapter la forme du barreau en conséquence.

Le brevet européen N° 2 215 531 propose de résoudre ce problème en utilisant un barreau de silicium spécifique orienté selon l'axe cristallographique {1,1,1} qui présente des caractéristiques mécaniques similaires dans plusieurs directions d'un plan. Ce mode de réalisation nécessite un silicium très particulier qui contraint fortement le procédé de fabrication de l'oscillateur mécanique.

Le problème technique de l'invention consiste donc à proposer un oscillateur mécanique en silicium monocristallin simple à fabriquer dont les caractéristiques mécaniques sont les mêmes dans toutes les directions d'un plan. En outre, l'invention vise également à limiter les variations des caractéristiques mécaniques en fonction de la température.

EXPOSE DE L'INVENTION

La présente invention propose de répondre à ce problème technique par un assemblage de deux couches de silicium monocristallin, dont les directions des réseaux cristallins sont décalées, en intercalant une couche de compensation thermique.

Selon un premier aspect, l'invention concerne un oscillateur mécanique muni d'un barreau, ledit barreau comportant une première couche de silicium comportant un réseau cristallin s'étendant selon une première direction d'un plan, une couche de compensation thermique constituée d'un matériau présentant un coefficient thermique du module d'Young de signe opposé à celui du silicium, et une deuxième couche de silicium comportant un réseau cristallin s'étendant selon une deuxième direction du plan, la première et la deuxième direction étant décalées d'un angle de 45° dans le plan des couches, et la couche de compensation thermique s'étendant entre les première et deuxième couches de silicium.

Au sens de l'invention, un barreau correspond donc à une structure composite comportant plusieurs couches de matériaux et non à une structure monolithique.

L'invention permet ainsi d'obtenir un oscillateur mécanique dont le comportement mécanique est identique dans toutes les directions du plan quel que soit la température. La variation du module d'Young pour le silicium monocristallin entre plusieurs directions du matériau est compensée par la présence de deux couches de silicium monocristallin identiques décalées de 45°. L'influence du coefficient thermique du module d'Young sur les caractéristiques mécaniques en fonction de la température est limitée à l'aide de la couche de compensation thermique. Ainsi, le barreau se comporte globalement sensiblement de la même manière quel que soit la direction du plan considérée et quel que soit la température. En choisissant, par exemple, une couche de compensation thermique isotrope dans le plan (ou amorphe), celle-ci présente également un coefficient thermique du module d'Young également isotrope. Cette couche de compensation thermique compense donc de manière homogène les variations de raideur subies par le barreau. En outre, il n'est pas nécessaire de prévoir un réseau monocristallin isotrope dans un plan qui nécessiterait un procédé de fabrication complexe.

Selon un mode de réalisation, ledit barreau comporte une troisième couche de silicium comportant un réseau cristallin s'étendant selon une troisième direction parallèle à la direction de la première couche de silicium, et une deuxième couche de compensation thermique constituée d'un matériau présentant un coefficient thermique du module d'Young de signe opposé à celui du silicium, chaque couche de compensation thermique étant disposée entre deux couches de silicium superposées, la direction de la couche de silicium, disposée entre les deux autres couches de silicium, étant décalée d'un angle de 45° avec la direction des deux autres couches de silicium. Ce mode de réalisation, en multipliant les couches, permet de limiter l'épaisseur de chaque couche de compensation thermique.

Selon un mode de réalisation, ledit barreau comporte une couche externe constituée d'un matériau présentant un coefficient thermique du module d'Young de signe opposé à celui du silicium. L'utilisation de la couche de compensation thermique s'étendant entre les première et deuxième couches de silicium permet de limiter l'épaisseur de la couche externe.

Selon un mode de réalisation, la couche de compensation thermique dont le matériau présente un coefficient thermique du module d'Young de signe opposé à celui du silicium est réalisée en oxyde de silicium. Ce mode de réalisation permet de faciliter le processus de fabrication de l'oscillateur mécanique car l'oxyde de silicium est obtenu à partir du silicium au contact de l'air ou dans une chambre d'Oxydation.

Selon un mode de réalisation, le rapport volumique entre le matériau présentant un coefficient thermique du module d'Young de signe opposé à celui du silicium et les couches de silicium, dépend de la nature de ce matériau. Par exemple, pour l'oxyde de silicium, il est compris entre 20% et 30%, préférentiellement voisin de 26%, à une température ambiante, environ 20°C. Ce mode de réalisation permet de compenser efficacement la sensibilité thermique du barreau. En outre, l'utilisation d'une couche de compensation thermique s'étendant entre les première et deuxième couches de silicium permet de limiter l'épaisseur de la couche externe ce qui présente des gains en temps de fabrication et en qualité de la couche externe.

Selon un mode de réalisation, l'oscillateur mécanique est un ressort spiral destiné à équiper le balancier d'un ensemble d'horlogerie mécanique et formé d'un barreau en spirale. L'invention est particulièrement adaptée aux ressorts spiraux utilisés pour la réalisation des montres de précision. L'invention est également adaptée à la réalisation d'autres oscillateurs ou résonateurs mécaniques, par exemple de type diapason.

Selon un deuxième aspect, l'invention concerne un procédé de réalisation d'un oscillateur mécanique précédemment décrit.

Selon un mode de réalisation, le procédé comporte les étapes suivantes : déposer une couche de compensation thermique sur une couche de silicium d'une première galette de silicium du type silicium sur isolant, graver le motif de l'oscillateur mécanique sur la couche de compensation thermique et sur la couche de silicium de la première galette de silicium sur isolant, sceller une deuxième galette de silicium du type silicium sur isolant sur la première galette de silicium avec une rotation de 45° par rapport à la première galette de silicium de sorte qu'une couche de silicium de la deuxième galette de silicium soit en contact avec la couche de compensation thermique, supprimer un substrat et une couche d'isolant de la première galette de silicium sur isolant, graver la couche de silicium de la deuxième galette de silicium en utilisant la première couche de silicium comme masque, et supprimer un substrat et une couche d'isolant de la deuxième galette de silicium sur isolant, la première et la deuxième galette de silicium de type silicium sur isolant étant constituées d'un substrat surmonté d'une couche d'isolant puis d'une couche de silicium monocristallin.

Au sens de l'invention, on entend par « déposer une couche de matériau », les procédés consistants à ajouter de la matière par dépôt, ajouter de la matière par croissance et transformation d'une couche existante ou reporter une couche annexe par scellement de la couche annexe.

Selon un mode de réalisation, le procédé comporte les étapes suivantes : déposer une première partie d'une couche de compensation thermique sur une couche de silicium d'une première galette de silicium du type silicium sur isolant, déposer une deuxième partie de la couche de compensation thermique sur une couche de silicium d'une deuxième galette de silicium du type silicium sur isolant, graver le motif de l'oscillateur mécanique sur la première partie de la couche de compensation thermique et sur la couche de silicium de la première galette de silicium sur isolant, graver le motif de l'oscillateur mécanique sur la deuxième partie de la couche de compensation thermique et sur la couche de silicium de la deuxième galette de silicium sur isolant, sceller la deuxième galette de silicium sur la première galette de silicium avec une rotation de 45° par rapport à la première galette de silicium de sorte que les deux parties de la couche de compensation thermique soient en contact, supprimer un substrat et une couche d'isolant de la deuxième galette de silicium sur isolant, et supprimer un substrat et une couche d'isolant de la première galette de silicium sur isolant, la première et la deuxième galette de silicium de type silicium sur isolant étant constituées d'un substrat surmonté d'une couche d'isolant puis d'une couche de silicium monocristallin.

Selon un mode de réalisation, le procédé comporte les étapes suivantes : graver le motif de l'oscillateur mécanique sur une première couche de silicium, une deuxième couche d'isolant et une deuxième couche de silicium d'une galette de silicium du type double silicium sur isolant, et supprimer un substrat et une première couche d'isolant de la galette de silicium, la première galette de silicium de type double silicium sur isolant étant constituée d'un substrat surmonté d'une première couche d'isolant, d'une première couche de silicium monocristallin, d'une deuxième couche d'isolant puis d'une deuxième couche de silicium monocristallin, la première et la deuxième couche de silicium de la galette de silicium de type double silicium sur isolant comportant des réseaux cristallins dont les directions sont décalées d'un angle de 45°.

Selon un mode de réalisation, le procédé comporte les étapes suivantes : graver le motif de l'oscillateur mécanique sur une deuxième couche de silicium et deuxième couche d'isolant d'une première galette de silicium du type double silicium sur isolant, sceller une deuxième galette de silicium sur la deuxième couche de silicium de la première galette de silicium, supprimer un substrat et une première couche d'isolant de la première galette de silicium, graver le motif de l'oscillateur mécanique sur une première couche de silicium de la première galette de silicium, et supprimer la deuxième galette de silicium, la première galette de silicium de type double silicium sur isolant étant constituée d'un substrat surmonté d'une première couche d'isolant, d'une première couche de silicium monocristallin, d'une deuxième couche d'isolant puis d'une deuxième couche de silicium monocristallin, la première et la deuxième couche de silicium de la galette de silicium de type double silicium sur isolant comportant des réseaux cristallins dont les directions sont décalées d'un angle de 45°, la deuxième galette de silicium étant constituée d'une seule couche de silicium surmontée ou non d'une couche d'isolant de compensation thermique.

Selon un mode de réalisation, le procédé comporte les étapes suivantes : déposer une couche de compensation thermique sur une couche de silicium d'une première galette de silicium du type silicium sur isolant, graver le motif de l'oscillateur mécanique sur la couche de compensation thermique et sur la couche de silicium de la première galette de silicium, sceller une deuxième galette de silicium sur la première galette de silicium avec une rotation de 45° par rapport à la première galette de silicium de sorte que la deuxième galette de silicium soit en contact avec la couche de compensation thermique, amincir la deuxième galette de silicium, graver le motif de l'oscillateur mécanique sur la deuxième galette de silicium, et supprimer un substrat et une couche d'isolant de la première galette de silicium, la première galette de silicium de type silicium sur isolant étant constituée d'un substrat surmonté d'une couche d'isolant puis d'une couche de silicium monocristallin, la deuxième galette de silicium étant constituée d'une seule couche de silicium surmontée ou non d'une couche d'isolant de compensation thermique.

Selon un mode de réalisation, le procédé comporte les étapes suivantes : amincir un substrat d'une galette de silicium du type silicium sur isolant, graver le motif de l'oscillateur mécanique sur une couche de silicium de la galette de silicium, déposer une couche de structuration sur le substrat de la galette de silicium, graver le motif de l'oscillateur mécanique sur un substrat et une couche d'isolant de la galette de silicium en utilisant la première couche de silicium comme masque, et supprimer la couche de structuration du substrat de la galette de silicium, la galette de silicium de type silicium sur isolant étant constituée d'un substrat en silicium surmonté d'une couche d'isolant puis d'une couche de silicium monocristallin, la première couche de silicium et le substrat en silicium de la galette de silicium comportant des réseaux cristallins dont les directions sont décalées d'un angle de 45°.

Selon un mode de réalisation, le procédé comporte une étape supplémentaire d'oxydation du barreau.

Selon un mode de réalisation, au moins une galette de silicium est du type triple silicium sur isolant constituée d'un substrat surmonté d'une première couche d'isolant, d'une première couche de silicium monocristallin, d'une deuxième couche d'isolant, d'une deuxième couche de silicium monocristallin, d'une troisième couche d'isolant puis d'une troisième couche de silicium monocristallin, la première et la deuxième couche de silicium de la galette de silicium de type double silicium sur isolant comportant des réseaux cristallins dont les directions sont décalées d'un angle de 45°.

## DESCRIPTION SOMMAIRE DES FIGURES

La manière de réaliser l'invention ainsi que les avantages qui en découlent, ressortiront bien du mode de réalisation qui suit, donné à titre indicatif mais non limitatif, à l'appui des figures annexées dans lesquelles les figures 1 à 12 représentent :

- Figure 1 : une vue en coupe d'un barreau d'un oscillateur mécanique selon un premier design de l'invention ;
- Figure 2 : une représentation schématique des différentes directions des axes du réseau cristallin sur un wafer de silicium de type <100> ;
- Figure 3 : une représentation des caractéristiques mécaniques d'une des deux couches de silicium du barreau de la Figure 1 en fonction de la direction dans le plan de l'axe du réseau cristallin;
- Figure 4 : une vue en coupe d'un barreau d'un oscillateur mécanique selon un deuxième design de l'invention ;
- Figure 5 : une vue en coupe d'un barreau d'un oscillateur mécanique selon un troisième design de l'invention ;

- Figure 6 : une vue en coupe d'un barreau d'un oscillateur mécanique selon un quatrième design de l'invention ;
- Figure 7 : une représentation schématique du procédé de réalisation du barreau de la Figure 1 selon un premier mode de réalisation ;
- Figure 8 : une représentation schématique du procédé de réalisation du barreau de la Figure 1 selon un deuxième mode de réalisation ;
- Figure 9 : une représentation schématique du procédé de réalisation du barreau de la Figure 1 selon un troisième mode de réalisation ;
- Figure 10 : une représentation schématique du procédé de réalisation du barreau de la Figure 1 selon un quatrième mode de réalisation ;
- Figure 11 : une représentation schématique du procédé de réalisation du barreau de la Figure 1 selon un cinquième mode de réalisation ; et
- Figure 12 : une représentation schématique du procédé de réalisation du barreau de la Figure 1 selon un sixième mode de réalisation.

## DESCRIPTION DETAILLEE DE L'INVENTION

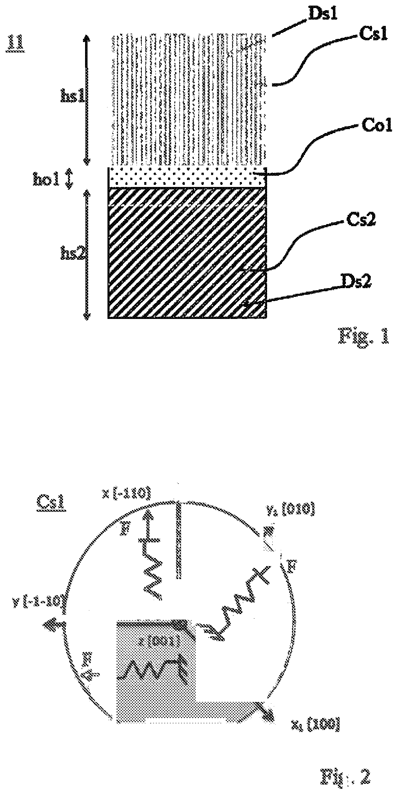

La Figure 1 illustre un barreau 11 d'un oscillateur mécanique, par exemple sous la forme d'un segment droit, d'un hélicoïde ou d'une spirale, comportant un empilement de trois couches : une première couche de silicium Cs1 monocristallin directement au contact d'une couche de compensation thermique Co1 directement au contact d'une deuxième couche de silicium Cs2 monocristallin. La première couche de silicium Cs1 s'étend sur une hauteur hs1 et sur toute la largeur L du barreau 11. La deuxième couche de silicium Cs2 s'étend sur une hauteur hs2 sensiblement égale à la hauteur hs1 et sur toute la largeur L du barreau 11. La couche de compensation thermique Co1 s'étend sur une hauteur ho1 très inférieure aux deux hauteurs hs1, hs2 et sur toute la largeur L du barreau 11.

Les deux couches de silicium Cs1, Cs2 comportent deux réseaux cristallins identiques. Chaque réseau cristallin de chaque couche de silicium Cs1, Cs2 comporte une direction prédéterminée Ds1, Ds2. On entend par «direction» des couches de silicium, la direction d'un réseau cristallin selon laquelle le réseau cristallin présente un maximum du module d'Young dans le plan de la couche de silicium correspondante Cs1, Cs2. Les hachures des Figures 1, 4, 5 et 6 permettent de visualiser de manière schématique les décalages entre les directions Ds1, Ds2 et Ds3. Cependant, les décalages entres les directions Ds1, Ds2 et Ds3 sont effectuées dans le plan des couches de silicium Cs1, Cs2 et Cs3 et ne sont donc pas visible de la même manière sur une vue en coupe réelle du barreau 11. On entend par « un réseau cristallin s'étend dans une direction » que le réseau cristallin comporte une structure cristalline dont le maximum du module d'Young est atteint dans la direction prédéterminée.

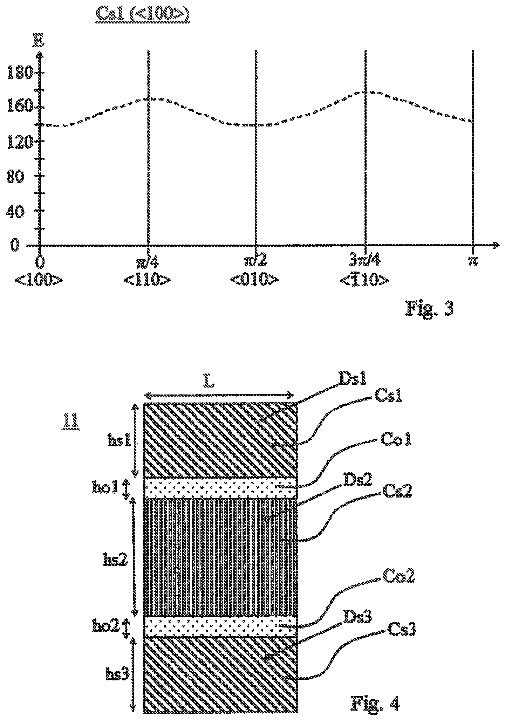

La Figure 2 illustre un réseau monocristallin du type <100> de la première couche de silicium Cs1 modélisé suivant trois ressorts linéaires. Pour un réseau cristallin du type <100>, la résistance mécanique de la première couche de silicium Cs1 dans la direction cristalline [-110] de l'axe x et dans la direction cristalline [-1-10] de l'axe y est plus importante que la résistance mécanique dans les directions cristallines [100] de l'axe xl et [010] de l'axe y1. La Figure 3 illustre les caractéristiques mécaniques d'une galette de type <100> en fonction de la direction angulaire d'un effort F repéré dans le plan du réseau cristallin du type <100> à température constante. E représente la variation du module d'Young. Cette grandeur mécanique présente des maxima locaux dans les directions <110> et <$\overline{1}$10> et des minima locaux dans les directions <100> et <010>. On peut ainsi en déduire que la raideur du réseau cristallin du type <100> de la première couche de silicium Cs1 est différente entre les directions x [-110] et y1 [010]. Cette raideur est identique entre les directions x [-110] et y [-1-10].

Compte tenu de l'épaisseur de la couche de compensation thermique Co1, les propriétés mécaniques du barreau 11 dépendent en grande partie des propriétés mécaniques des deux couches de silicium Cs1, Cs2. Si les deux couches de silicium Cs1, Cs2 présentent la même orientation cristalline et la même hauteur de sorte que hs1=hs2 ; la résistance $F_{tot\,X}$ du barreau 11 suivant la direction x [-110] est égale à la somme des résistances F1, F2 des deux couches de silicium Cs1, Cs2. Le module d'Young $E_{-110}$ suivant la direction x [-110] des deux couches de silicium Cs1, Cs2 étant identique, les résistances F1 et F2 sont également identiques de sorte que :

$$F_1 = F_2 = \frac{hs1 \times L \times E_{-110}}{\varepsilon} \; ;$$

avec $\varepsilon$ représentant le coefficient de déformation.

La résistance $F_{tot\,X}$ du barreau 11 suivant la direction x [-110] est donc égale à :

$$F_{tot\,X} = F_1 + F_2 = \frac{2\times hs1 \times L \times E_{-110}}{\varepsilon}\ .$$

Cette résistance $F_{tot\,X}$ suivant la direction x [-110] est identique suivant la direction Y [-1-10] dans le cas d'un spiral mono-âme.

Cependant, la résistance $F_{tot\,y1}$ du barreau 11 suivant la direction y1 [010] est égale à :

$$F_{tot\,y1} = F_1 + F_2 = \frac{2\times hs1 \times L \times E_{010}}{\varepsilon}\ .$$

Or, la Figure 3 révèle que le module d'Young $E_{010}$ des couches de silicium Cs1, Cs2 suivant la direction y1 [010] est inférieur au module d'Young $E_{-110}$ des couches de silicium Cs1, Cs2 suivant la direction x [-110] ce qui induit une différence des résistances entre les directions x [-110] et y1 [010]. Ainsi, la résistance $F_{tot\,X}$ du barreau 11 suivant la direction x [-110] est supérieure à la résistance $F_{tot\,y1}$ du barreau 11 suivant la direction y1 [010]. Le barreau 11 présente ainsi une faiblesse de sa résistance dans la direction y1 [010].

L'invention propose de compenser cette différence de résistance par un décalage des directions Ds1, Ds2 des couches de silicium Cs1 et Cs2 d'un angle de 45° dans le plan des couches de silicium Cs1, Cs2. Ainsi, le module d'Young dans une direction donnée est différent entre les deux couches Cs1 et Cs2. Par exemple, suivant la direction y1 [010], le module d'Young $E_{-110}$ de la première couche de silicium Cs1 diffère du module d'Young $E_{010}$ de la deuxième couche de silicium Cs2. La résistance $F_{tot\,X}$ du barreau 11 suivant la direction x [-110] est donc égale à :

$$F_{tot\,X} = F_1 + F_2 = \frac{hs1}{\varepsilon}\ \times L \times (E_{-110} + E_{010})\ .$$

La résistance $F_{tot\,y1}$ du barreau 11 suivant la direction y1 [010] est égale à :

$$F_{tot\,y1} = F_1 + F_2 = \frac{hs1}{\varepsilon}\ \times L \ \times (E_{010} + E_{1-10})\ .$$

Etant donné que $E_{1-10}$ est égal à $E_{-110}$, les résistances sont identiques dans les deux directions x [-110] et y1 [010]. La structure du barreau 11 de la Figure 1 permet ainsi d'obtenir des caractéristiques mécaniques identiques dans toutes les directions x, y et y1 du réseau cristallin.

La couche de compensation thermique Co1 est constituée d'un matériau présentant un coefficient thermique du module d'Young de signe opposé à celui du silicium de sorte que la variation de la résistance mécanique des couches de silicium Cs1, Cs2 en fonction de la température soit, au moins partiellement, compensée par la couche de compensation thermique Co1. De préférence, la couche de compensation thermique Co1 est de l'oxyde de silicium. Le coefficient thermique du module d'Young pour le silicium est de -64.10$^{-6}$K$^{-1}$ et le coefficient thermique du module d'Young pour l'oxyde de silicium est de 187,5.10$^{-6}$K$^{-1}$ à une température ambiante, environ 20°C. Ainsi, pour compenser, au moins partiellement, la variation de la résistance mécanique des couches de silicium Cs1, Cs2 en fonction de la température, le rapport volumique entre la couche de compensation thermique Co1 et les couches de silicium Cs1, Cs2 soit au moins de 20 % à une température ambiante d'environ 20°C. Sur la Figure 1, la surface de la section ho1.L est donc au moins égale à 20 % de la surface des sections L.hs1 et L.hs2.

La Figure 4 illustre une variante de l'invention dans laquelle le barreau 11 comporte trois couches de silicium Cs1, Cs2, Cs3 entrecoupées par deux couches de compensation thermique Co1, Co2. La première et la troisième couche de silicium Cs1, Cs3 comportent des réseaux cristallins orientés dans la même direction Ds1, Ds3. La deuxième couche de silicium Cs2 disposée entre la première et la troisième couche de silicium Cs1, Cs3 comporte un réseau cristallin dont la direction Ds2 est décalée d'un angle de 45° avec les directions Ds1, Ds3. Afin d'obtenir des caractéristiques mécaniques identiques dans toutes les directions x, y et y1 du réseau cristallin, la hauteur hs2 de la deuxième couche de silicium Cs2 doit être égale à la somme des hauteurs hs1 et hs3 des deux autres couches de silicium Cs1, Cs3. Afin de compenser, au moins partiellement, la dérive en température, la somme des hauteurs ho1 et ho2 doit être au moins égale, dans le cas de l'oxyde de silicium, à 20 % de la somme des hauteurs hs1, hs2 et hs3.

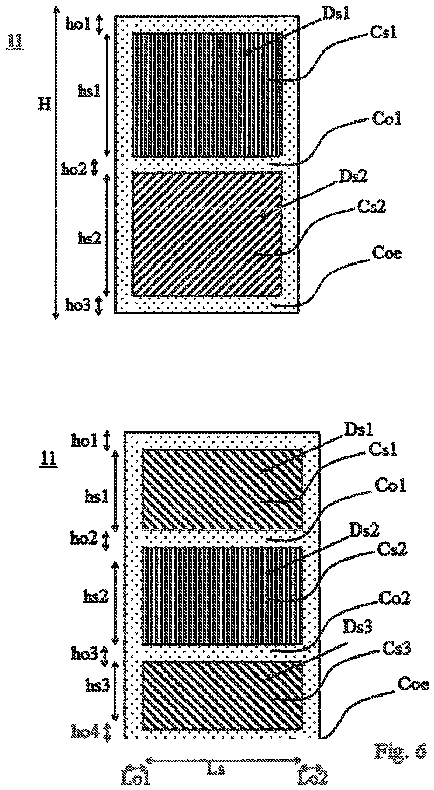

Les Figures 5 et 6 illustrent une variante dans laquelle une couche de compensation thermique est également disposée autour du barreau 11 des Figures 1 et 4. Ce mode de réalisation permet de limiter l'épaisseur de la couche de compensation thermique Co1 disposée entre les couches de silicium Cs1, Cs2. Par exemple, dans le cas de la Figure 5, la surface de la couche de compensation thermique comprend les aires suivantes :

- ho1.L, aire de la couche extérieure Coe au-dessus du barreau 11,
- Lo1.H, aire de la couche extérieure Coe sur la gauche du barreau 11,
- Lo2.H, aire de la couche extérieure Coe sur la droite du barreau 11,
- ho3.L, aire de la couche extérieure Coe au-dessous du barreau 11 et
- ho2.L, aire de la couche Co1 entre les couches de silicium Cs1, Cs2.

La somme de ces surfaces doit être également égale, dans le cas de l'oxyde de silicium, à au moins 20 % de la somme des surfaces hs1.Ls et hs2.Ls des couches de silicium Cs1, Cs2 afin de compenser la dérive en température. Ainsi, l'épaisseur des couches de compensation thermiques, c'est-à-dire de la couche interne Co1 et de la couche externe Coe, est réduite par rapport au mode de réalisation de la Figure 1. La Figure 6 illustre un mode de réalisation identique dans lequel le barreau comporte trois couches de silicium Cs1, Cs2 et Cs3 tel que décrit avec la Figure 4.

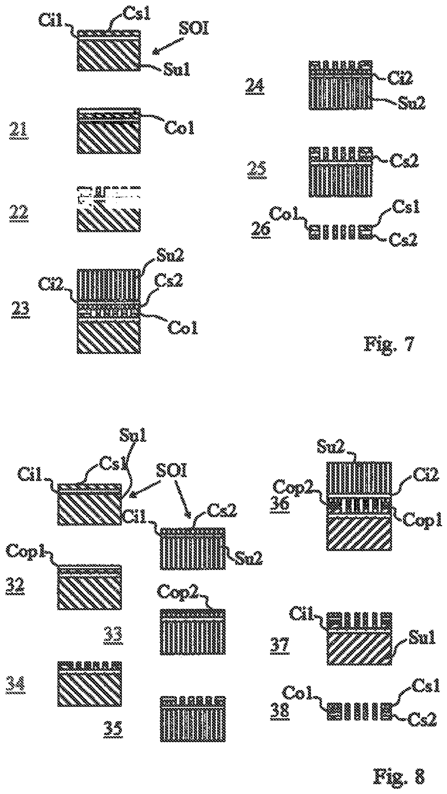

Les Figures 7 à 12 illustrent des procédés de réalisation du barreau 11 de la Figure 1. Le procédé de la Figure 7 utilise deux galettes de silicium du type silicium sur isolant SOI. Chaque galette du type silicium sur isolant SOI comporte un substrat Sul, Su2 surmonté d'une couche d'isolant Ci1, Ci2 puis d'une couche de de silicium monocristallin Cs1, Cs2. Le substrat Sul, Su2, peut être réalisé en silicium. Dans une première étape 21, une couche de compensation thermique Co1 est déposée sur la couche de silicium Cs1 de la première galette du type SOI. Dans une deuxième étape 22, un motif de l'oscillateur mécanique est gravé sur la couche de compensation thermique Co1 et sur la couche de silicium Cs1. Dans une troisième étape 23, la couche de silicium Cs2 de la deuxième galette est scellée sur la couche de compensation thermique Co1. La deuxième galette est décalée d'un angle de 45° par rapport à la première galette avant cette étape 23 de scellement de sorte que les directions Ds1, Ds2 des réseaux cristallins soient également décalées d'un angle de 45°. Dans une étape 24, l'assemblage est retourné et le substrat Sul ainsi que la couche d'isolant Ci1 de la première galette sont retirés. Dans une étape 25, la couche de silicium Cs2 de la deuxième galette est gravée au motif de l'oscillateur mécanique en utilisant la première couche de silicium comme masque de gravure. La gravure peut être effectuée par une technique de gravure ionique réactive profonde (également connu sous l'acronyme DRIE pour « Deep Reactive Ion Etching »). Le substrat Su2 et la couche d'isolant Ci2 de la deuxième galette de silicium sont ensuite retirés dans une étape 26 pour libérer l'oscillateur mécanique.

La Figure 8 illustre un procédé de réalisation utilisant également deux galettes SOI. Dans les étapes 32 et 33, deux parties Cop1, Cop2 de la couche de compensation thermique Co1 sont déposées respectivement sur chaque couche de silicium Cs1, Cs2 des deux galettes SOI. Dans les étapes 34, 35, les motifs de l'oscillateur sont ensuite gravés sur les deux parties Cop1 et Cop2 de la couche de compensation thermique Co1 ainsi que sur les deux couches de silicium Cs1, Cs2 des deux galettes. Dans une étape 36, les deux parties Cop1, Cop2 sont ensuite scellées avec un décalage de 45° entre les galettes de sorte à former la couche complète de compensation thermique Co1. Les étapes 37, 38 consistent à supprimer les deux substrats Sul, Su2 ainsi que les deux couches d'isolant Ci1, Ci2 afin de libérer l'oscillateur mécanique.

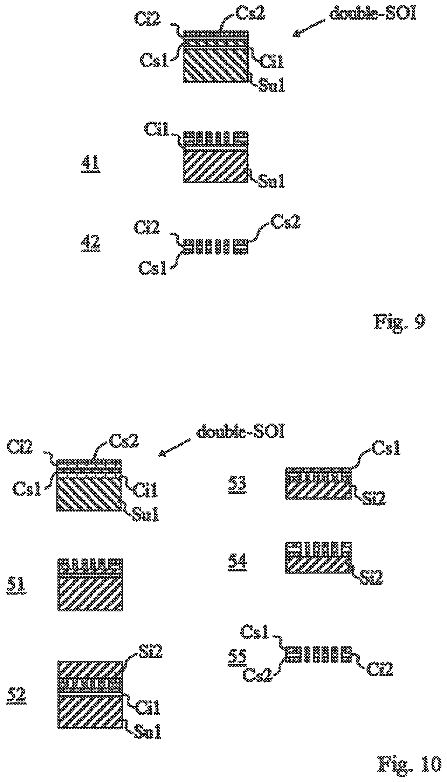

La Figure 9 illustre un procédé de réalisation utilisant une seule galette du type double-SOI. Une galette du type double-SOI est constituée d'un substrat Sul surmonté d'une première couche d'isolant Ci1, d'une première couche de silicium monocristallin Si1, d'une deuxième couche d'isolant Ci2 puis d'une deuxième couche de silicium monocristallin Si2. La deuxième couche d'isolant Ci2 réalise ainsi la fonction de la couche de compensation thermique Co1 du barreau 11. La première couche de silicium Cs1 et la deuxième couche de silicium Cs2 comportent des réseaux cristallins dont les directions sont décalées d'un angle de 45°. Une première étape 41 consiste à graver le motif de l'oscillateur mécanique dans la première couche de silicium Cs1, la deuxième couche d'isolant Ci2 et la deuxième couche de silicium Cs2. Une seconde étape 42 consiste à retirer le substrat Sul et la première couche d'isolant Ci1 pour libérer l'oscillateur mécanique.

La Figure 10 illustre une variante du procédé de la Figure 9 utilisant une galette du type double-SOI. Une première étape 51 consiste à graver le motif de l'oscillateur mécanique dans la deuxième couche de silicium Cs2 et la deuxième couche d'isolant Ci2. Dans une deuxième étape 52, une galette de silicium Si2 est scellée sur la deuxième couche de silicium Cs2. Cette galette de silicium Si2 est une couche sacrificielle qui sert uniquement de support à la structure et sera supprimée dans une étape ultérieure. Dans une étape 53, l'assemblage est retourné et le substrat Sul ainsi que la première couche d'isolant Ci1 de la première galette sont retirés. Le motif de l'oscillateur mécanique est gravé sur la première couche de silicium Cs1 dans une étape 54 et, dans une étape 55, la galette de silicium Si2 est retirée pour libérer l'oscillateur mécanique. Cette variante du procédé de la Figure 9 peut être mise en oeuvre lorsque le barreau 11 est trop épais et que l'étape 41 de gravure ne permet pas de graver correctement la première couche de silicium Cs1.

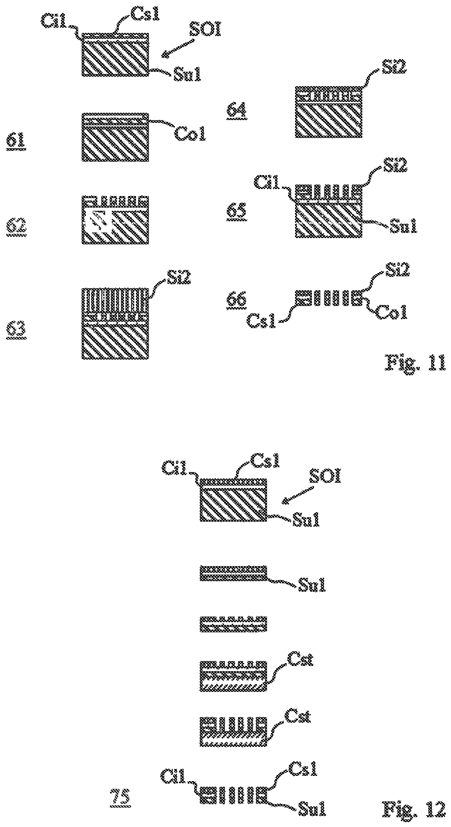

La Figure 11 illustre un procédé de réalisation utilisant une galette du type SOI et une galette de silicium Si2. Dans une première étape 61, une couche de compensation thermique Co1 est déposée sur la couche de silicium Cs1 de la première galette du type SOI. Dans une deuxième étape 62, un motif de l'oscillateur mécanique est gravé sur la couche de compensation thermique Co1 et sur la couche de silicium Cs1. La galette de silicium Si2 est ensuite scellée avec un décalage de 45° sur la couche de compensation thermique Co1 dans une étape 63. L'étape 64 consiste à amincir la galette de silicium Si2 jusqu'à atteindre la hauteur hs2 souhaitée pour la deuxième couche de silicium Cs2 du barreau 11 de la Figure 1. Dans une étape 65, le motif de l'oscillateur mécanique est gravé sur la deuxième couche de silicium Cs2 formé par la galette de silicium Si2 et, dans une étape 66, le substrat Sul et la couche d'isolant Ci1 sont retirés pour libérer l'oscillateur mécanique.

La Figure 12 illustre un procédé de réalisation utilisant une seule galette du type SOI dans laquelle le substrat Sul est réalisé en silicium et forme la deuxième couche de silicium Cs2 de la Figure 1. La couche de compensation thermique Co1 est formée par la couche d'isolant Ci1 préférentiellement réalisée en oxyde de silicium. Une première étape 71 consiste à amincir le substrat Sul jusqu'à atteindre la hauteur hs2 souhaitée pour la deuxième couche de silicium Cs2 du barreau 11 de la Figure 1. Dans une étape 72, le motif de l'oscillateur mécanique est gravé sur la couche de silicium Cs1. Une couche de structuration Cst est ensuite déposée sur le substrat aminci Sul dans une étape 73 afin de rigidifier la structure puis le motif de l'oscillateur mécanique est gravé dans les couches d'isolant Ci1 et de substrat Sul dans une étape 74. Dans une étape 75, la couche de structuration Cst est retirée pour libérer l'oscillateur mécanique.

En variante, ces procédés peuvent être adaptés pour réaliser une des variantes des Figures 4 à 6. Par exemple, la réalisation d'une couche externe Coe de compensation thermique peut être réalisée dans une chambre d'oxydation du silicium formant ainsi une couche d'oxyde de silicium autour du barreau 11. La réalisation d'une deuxième couche de compensation thermique Co2 et d'une troisième couche de silicium Cs3 peut être réalisée, par exemple, par le scellement d'une troisième galette de type silicium sur isolant et par des étapes supplémentaires de gravure correspondantes.

L'invention permet ainsi d'obtenir un oscillateur mécanique dont la raideur est isotrope dans le plan et indépendante de la température sans augmenter la taille du barreau et sans utiliser une couche de silicium isotrope dans le plan.

## Revendications

1. Oscillateur mécanique muni d'un barreau (11), ledit barreau (11) comportant :

   - une première couche de silicium (Cs1) comportant un réseau cristallin s'étendant selon une première direction (Ds1) d'un plan, et
   - une couche de compensation thermique (Co1) constituée d'un matériau présentant un coefficient thermique du module d'Young de signe opposé à celui du silicium,

   **caractérisé en ce que** ledit barreau (11) comporte également une deuxième couche de silicium (Cs2) comportant un réseau cristallin s'étendant selon une deuxième direction (Ds2) du plan,

   - la première (Ds1) et la deuxième (Ds2) direction étant décalées d'un angle de 45° dans le plan des couches, et
   - la couche de compensation thermique (Co1) s'étendant entre les première et deuxième couches de silicium (Cs1, Cs2).

2. Oscillateur mécanique selon la revendication 1, **caractérisé en ce que** ledit barreau (11) comporte :

   - une troisième couche de silicium (Cs3) comportant un réseau cristallin s'étendant selon une troisième direction (Ds3) parallèle à la direction de la première couche de silicium (Ds1), et
   - une deuxième couche de compensation thermique (Co2) constituée d'un matériau présentant un coefficient thermique du module d'Young de signe opposé à celui du silicium,
   - chaque couche de compensation thermique (Co1, Co2) étant disposée entre deux couches de silicium (Cs1, Cs2, Cs3) superposées,
   - la direction de la deuxième couche de silicium (Cs2), disposée entre les deux autres couches de silicium (Cs1, Cs3), étant décalée d'un angle de 45° avec la direction des deux autres couches de silicium (Cs1, Cs3).

3. Oscillateur mécanique selon la revendication 1 ou 2, **caractérisé en ce que** ledit barreau (11) comporte une couche externe (Coe) de compensation thermique constituée d'un matériau présentant un coefficient thermique du module d'Young de signe opposé à celui du silicium.

4. Oscillateur mécanique selon l'une des revendications 1 à 3, **caractérisé en ce que** la couche de compensation thermique (Co1, Co2, Coe) dont le matériau présente un coefficient thermique du module d'Young de signe opposé à celui du silicium est réalisée en oxyde de silicium (SiO2).

**5.** Oscillateur mécanique selon l'une des revendications 1 à 4, **caractérisé en ce que** le rapport volumique entre le matériau présentant un coefficient thermique du module d'Young de signe opposé à celui du silicium et les couches de silicium (Cs1, Cs2, Cs3) est compris entre 20 % et 30 %, préférentiellement voisin de 26 %, à une température ambiante, environ 20°C.

**6.** Oscillateur mécanique selon l'une des revendications 1 à 5, **caractérisé en ce que** l'oscillateur mécanique est un ressort spiral destiné à équiper le balancier d'un ensemble d'horlogerie mécanique et formé d'un barreau (11) en spirale.

**7.** Procédé de réalisation d'un oscillateur mécanique selon l'une des revendications 1 à 6, **caractérisé en ce qu'**il comporte:

- la gravure (22) d'un motif de l'oscillateur mécanique sur la première couche de silicium (Cs1), sur la couche de compensation thermique (Co1) et sur la deuxième couche de silicium (Cs2).

**8.** Procédé de réalisation d'un oscillateur mécanique selon la revendication 7, **caractérisé en ce qu'**il comporte les étapes suivantes :

- déposer (21) une couche de compensation thermique (Co1) sur une première couche de silicium (Cs1) d'une première galette de silicium du type silicium sur isolant (SOI),
- graver (22) le motif de l'oscillateur mécanique sur la couche de compensation thermique (Co1) et sur la première couche de silicium (Cs1) de la première galette de silicium sur isolant (SOI),
- sceller (23) une deuxième galette de silicium du type silicium sur isolant (SOI) sur la première galette de silicium avec une rotation de 45° par rapport à la première galette de silicium de sorte qu'une deuxième couche de silicium (Cs2) de la deuxième galette de silicium soit en contact avec la couche de compensation thermique (Co1),
- supprimer (24) un substrat (Su1) et une couche d'isolant (Ci1) de la première galette de silicium sur isolant (SOI),
- graver (25) la deuxième couche de silicium (Cs2) de la deuxième galette de silicium en utilisant la première couche de silicium (Cs1) comme masque, et
- supprimer (26) un substrat (Su2) et une couche d'isolant (Ci2) de la deuxième galette de silicium sur isolant (SOI),
- la première et la deuxième galette de silicium de type silicium sur isolant (SOI) étant constituées d'un substrat (Su1, Su2) surmonté d'une couche d'isolant (Ci1, Ci2) puis d'une desdites première ou deuxième couches de silicium monocristallin (Cs1, Cs2).

**9.** Procédé de réalisation d'un oscillateur mécanique selon la revendication 7, **caractérisé en ce qu'**il comporte les étapes suivantes :

- déposer (32) une première partie (Cop1) d'une couche de compensation thermique (Co1) sur une première couche de silicium (Cs1) d'une première galette de silicium du type silicium sur isolant (SOI),
- déposer (33) une deuxième partie (Cop2) de la couche de compensation thermique (Co1) sur une deuxième couche de silicium (Cs2) d'une deuxième galette de silicium du type silicium sur isolant (SOI),
- graver (34) le motif de l'oscillateur mécanique sur la première partie (Cop1) de la couche de compensation thermique (Co1) et sur la première couche de silicium (Cs1) de la première galette de silicium sur isolant (SOI),
- graver (35) le motif de l'oscillateur mécanique sur la deuxième partie (Cop2) de la couche de compensation thermique (Co1) et sur la deuxième couche de silicium (Cs2) de la deuxième galette de silicium sur isolant (SOI),
- sceller (36) la deuxième galette de silicium sur la première galette de silicium avec une rotation de 45° par rapport à la première galette de silicium de sorte que les deux parties (Cop1, Cop2) de la couche de compensation thermique (Co1) soient en contact,
- supprimer (37) un substrat (Su2) et une couche d'isolant (Ci2) de la deuxième galette de silicium sur isolant (SOI), et
- supprimer (38) un substrat (Su1) et une couche d'isolant (Ci1) de la première galette de silicium sur isolant (SOI),
- la première et la deuxième galette de silicium de type silicium sur isolant (SOI) étant constituées d'un substrat (Su1, Su2) surmonté d'une couche d'isolant (Ci1, Ci2) puis d'une desdites première ou deuxième couches de silicium (Cs1, Cs2) monocristallin.

**10.** Procédé de réalisation d'un oscillateur mécanique selon la revendication 7, **caractérisé en ce qu'**il comporte les étapes suivantes :

- graver (41) le motif de l'oscillateur mécanique sur une première couche de silicium (Cs1), une deuxième couche d'isolant (Ci2) et une deuxième couche de silicium (Cs2) d'une galette de silicium du type double silicium sur isolant (double-SOI), et
- supprimer (42) un substrat (Su1) et une première couche d'isolant (Ci1) de la galette de silicium,
- la première galette de silicium de type double silicium sur isolant (double-SOI) étant constituée d'un substrat (Su1) surmonté d'une première couche d'isolant (Ci1), d'une première couche de silicium (Cs1) monocristallin, d'une deuxième couche d'isolant (Ci2) puis d'une deuxième couche de silicium (Cs2) monocristallin, la première et la deuxième couche de silicium (Cs1, Cs2) de la galette de silicium de type double silicium sur isolant (double-SOI) comportant des réseaux cristallins dont les directions sont décalées d'un angle de 45°.

**11.** Procédé de réalisation d'un oscillateur mécanique selon la revendication 7, **caractérisé en ce qu'**il comporte les étapes suivantes :

- graver (51) le motif de l'oscillateur mécanique sur une deuxième couche de silicium (Cs2) et deuxième couche d'isolant (Ci2) d'une première galette de silicium du type double silicium sur isolant (double-SOI),
- sceller (52) une deuxième galette de silicium (Si2) sur la deuxième couche de silicium (Cs2) de la première galette de silicium,
- supprimer (53) un substrat (Su1) et une première couche d'isolant (Ci1) de la première galette de silicium,
- graver (54) le motif de l'oscillateur mécanique sur une première couche de silicium (Cs1) de la première galette de silicium, et
- supprimer (55) la deuxième galette de silicium (Si2),
- la première galette de silicium de type double silicium sur isolant (double-SOI) étant constituée d'un substrat (Su1) surmonté d'une première couche d'isolant (Ci1), d'une première couche de silicium (Cs1) monocristallin, d'une deuxième couche d'isolant (Ci2) puis d'une deuxième couche de silicium (Cs2) monocristallin, la première et la deuxième couche de silicium (Cs1, Cs2) de la galette de silicium de type double silicium sur isolant (double-SOI) comportant des réseaux cristallins dont les directions sont décalées d'un angle de 45°,
- la deuxième galette de silicium (Si2) étant constituée d'une seule couche de silicium surmontée ou non d'une couche d'isolant.

**12.** Procédé de réalisation d'un oscillateur mécanique selon la revendication 7, **caractérisé en ce qu'**il comporte les étapes suivantes :

- déposer (61) une couche de compensation thermique (Co1) sur une couche de silicium (Cs1) d'une première galette de silicium du type silicium sur isolant (SOI),
- graver (62) le motif de l'oscillateur mécanique sur la couche de compensation thermique (Co1) et sur la couche de silicium (Cs1) de la première galette de silicium,
- sceller (63) une deuxième galette de silicium (Si2) incorporant ladite deuxième couche de silicium (Cs2) sur la première galette de silicium avec une rotation de 45° par rapport à la première galette de silicium de sorte que la deuxième galette de silicium (Si2) soit en contact avec la couche de compensation thermique (Co1),
- amincir (64) la deuxième galette de silicium (Si2),
- graver (65) le motif de l'oscillateur mécanique sur la deuxième galette de silicium (Si2), et
- supprimer (66) un substrat (Su1) et une couche d'isolant (Ci1) de la première galette de silicium,
- la première galette de silicium de type silicium sur isolant (SOI) étant constituée d'un substrat (Su1) surmonté d'une couche d'isolant (Ci1) puis d'une couche de silicium (Cs1) monocristallin,
- la deuxième galette de silicium (Si2) étant constituée d'une seule couche de silicium surmontée ou non d'une couche d'isolant.

**13.** Procédé de réalisation d'un oscillateur mécanique selon la revendication 7, **caractérisé en ce qu'**il comporte les étapes suivantes :

- amincir (71) un substrat (Su1) formant ladite deuxième couche de silicium (Cs2) d'une galette de silicium du type silicium sur isolant (SOI),
- graver (72) le motif de l'oscillateur mécanique sur une couche de silicium (Cs1) de la galette de silicium,
- déposer (73) une couche de structuration (Cst) sur le substrat (Su1) de la galette de silicium,
- graver (74) le motif de l'oscillateur mécanique sur un substrat (Su1) et une couche d'isolant (Ci1) de la galette de silicium en utilisant la première couche de silicium comme masque, et
- supprimer (75) la couche de structuration (Cst) du substrat (Su1) de la galette de silicium,
- la galette de silicium de type silicium sur isolant (SOI) étant constituée d'un substrat (Su1) en silicium surmonté d'une couche d'isolant (Ci1) puis d'une couche de silicium (Cs1) monocristallin, la première couche de silicium (Cs1) et le substrat (Su1) en silicium de la galette de silicium du type silicium sur isolant (SOI) comportant des réseaux cristallins dont les directions sont décalées d'un angle de 45°.

14. Procédé de réalisation d'un oscillateur mécanique selon l'une des revendications 8 à 13, **caractérisé en ce qu'**il comporte une étape supplémentaire d'oxydation du barreau.

15. Procédé de réalisation d'un oscillateur mécanique selon l'une des revendications 8 à 14, **caractérisé en ce qu'**il comporte une étape supplémentaire consistant à apposer une deuxième couche de compensation thermique (Co2) et une troisième couche de silicium (Cs3).

**Patentansprüche**

1. Mechanischer Oszillator, der mit einem Streifen (11) versehen ist, dieser vorgenannte Streifen (11) umfasst:

   - eine erste Siliziumschicht (Cs1) mit einem sich in einer ersten Richtung (Ds1) einer Ebene erstreckenden Kristallgitter, und
   - eine thermische Kompensationsschicht (Co1), bestehend aus einem Material, dessen Temperaturkoeffizient des Elastizitätsmoduls ein Vorzeichen entgegengesetzt zu dem des Siliziums hat,

   **dadurch gekennzeichnet, dass** dieser Streifen (11) auch eine zweite Siliziumschicht (Cs2) enthält, mit einem Kristallgitter, das sich in einer zweiten Richtung (Ds2) der Ebene erstreckt,

   - wobei die erste (Ds1) und die zweite (Ds2) Richtung in einem Winkel von 45 ° in der Ebene der Schichten versetzt sind
   - und wobei sich die thermische Kompensationsschicht (Co1) zwischen der ersten und der zweiten Siliziumschicht.(Cs1, Cs2) erstreckt.

2. Mechanischer Oszillator gemäß Anspruch 1, **dadurch gekennzeichnet, dass** der genannte Streifen (11) enthält:

   - eine dritte Siliziumschicht (Cs3), mit einem Kristallgitter, das sich in einer dritten Richtung (Ds3) erstreckt, parallel zur Richtung der ersten Siliziumschicht (Ds1), und
   - eine zweite thermische Kompensationsschicht (Co2), bestehend aus einem Material, dessen Temperaturkoeffizient des Elastizitätsmoduls ein Vorzeichen entgegengesetzt zu dem des Siliziums hat,
   - jede thermische Kompensationsschicht (Co1, Co2), ist zwischen zwei übereinander liegenden Siliziumschichten (Cs1, Cs2, Cs3) angeordnet,
   - Die Richtung der zweiten Siliziumschicht (Cs2), angeordnet zwischen den beiden anderen Siliziumschichten (Cs1, Cs3) ist in einem Winkel von 45 ° zur Richtung der beiden anderen Siliziumschichten (Cs1, Cs3) versetzt.

3. Mechanischer Oszillator gemäß Anspruch 1 oder 2, **dadurch gekennzeichnet, dass** dieser Streifen (11) eine außenliegende thermische Kompensationsschicht (Coe) hat, bestehend aus einem Material dessen Temperaturkoeffizient des Elastizitätsmoduls ein Vorzeichen entgegengesetzt zu dem des Siliziums hat.

4. Mechanischer Oszillator gemäß einem der Ansprüche 1 bis 3, **dadurch gekennzeichnet, dass** die thermische Kompensationsschicht (Co1, Co2, Coe) aus einem Material, dessen Temperaturkoeffizient des Elastizitätsmoduls ein Vorzeichen entgegengesetzt zu dem des Siliziums hat, aus Siliziumoxid (SiO2) besteht.

5. Mechanischer Oszillator gemäß einem der Ansprüche 1 bis 4, **dadurch gekennzeichnet, dass** das Volumenverhältnis zwischen dem Material mit einem Temperaturkoeffizienten des Elastizitätsmoduls mit einem Vorzeichen entgegengesetzt zu dem des Siliziums und den Siliziumschichten (Cs1, Cs2, Cs3) zwischen 20 % und 30 % liegt, möglichst in Nähe von 26 % bei Raumtemperatur, ungefähr 20°.

6. Mechanischer Oszillator gemäß einem der Ansprüche 1 bis 5, **dadurch gekennzeichnet, dass** der mechanische Oszillator eine Spiralfeder ist, zur Ausrüstung der Unruh einer mechanischen Uhr und aus einem spiralförmigen Streifen (11) gebildet.

7. Verfahren zur Herstellung eines mechanischen Oszillators gemäß einem der Ansprüche 1 bis 6, **dadurch gekenn-**

**zeichnet, dass** es umfasst:

- Gravieren (22) eines Musters des mechanischen Oszillators auf der ersten Siliziumschicht (Cs1), auf der thermischen Kompensationsschicht (Co1) und auf der zweiten Siliziumschicht (Cs2).

8.  Verfahren zur Herstellung eines mechanischen Oszillators gemäß Anspruch 7, **dadurch gekennzeichnet, dass** es die folgenden Schritte umfasst:

- Ablagerung (21) einer thermischen Kompensationsschicht (Co1) auf einer ersten Siliziumschicht (Cs1) eines ersten Silizium-Wafers vom Typ Silicon-on-Insulator (SOI),
- Gravieren (22) des Musters des mechanischen Oszillators auf der thermischen Kompensationsschicht (Co1) und auf der ersten Siliziumschicht (Cs1) des ersten Silicon-on-Insulator-Wafers (SOI),
- Dichte Verbindung (23) eines zweiten Silizium-Wafers vom Typ Silicon-on-Insulator (SOI), auf dem ersten Silizium-Wafer mit einer Drehung um 45° bezogen auf den ersten Silizium-Wafer, so dass eine zweite Siliziumschicht (Cs2) des zweiten Silizium-Wafers Kontakt mit der thermischen Kompensationsschicht (Co1) hat,
- Supprimieren (24) eines Substrats (Su1) und einer Isolierschicht (Ci1) vom zweiten Silizium-Wafer vom Typ Silicon-on-Insulator (SOI),
- Gravieren (25) der zweiten Siliziumschicht (Cs2) vom zweiten Silizium-Wafer, unter Verwendung der ersten Siliziumschicht (Cs1) als Maske, und Beseitigen (26) eines Substrats (Su2) und einer Isolierschicht (Ci2) vom zweiten Silizium-Wafer auf Isolierung (SOI),
- der erste und der zweite Silizium-Wafer vom Typ Silicon-on-Insulator (SOI) bestehen aus einem Substrat (Su1, Su2) über dem sich eine Isolierschicht (Ci1, Ci2) befindet, dann eine der genannten ersten oder zweiten monokristalline n Siliziumschichten (Cs1, Cs2).

9.  Verfahren zur Herstellung eines mechanischen Oszillators gemäß Anspruch 7, **dadurch gekennzeichnet, dass** es die folgenden Schritte umfasst:

- Ablagerung (32) eines ersten Teils (Cop1) einer thermischen Kompensationsschicht (Co1) auf einer ersten Siliziumschicht (Cs1) eines ersten Silizium-Wafers vom Typ Silicon-on-Insulator (SOI),
- Ablagerung (33) eines zweiten Teils (Cop2) einer thermischen Kompensationsschicht (Co1) auf einer zweiten Siliziumschicht (Cs2) eines zweiten Silizium-Wafers vom Typ Silicon-on-Insulator (SOI),
- Gravieren (34) des Musters des mechanischen Oszillators auf dem ersten Teil (Cop1) der thermischen Kompensationsschicht (Co1) und auf der ersten Siliziumschicht (Cs1) des ersten Silicon-on-Insulator-Wafers (SOI),
- Gravieren (35) des Musters des zweiten Teils (Cop2) des mechanischen Oszillators auf der thermischen Kompensationsschicht (Co1) und auf der zweiten Siliziumschicht (Cs2) des zweiten Silicon-on-Insulator-Wafers (SOI),
- dichte Verbindung (36) des zweiten Silizium-Wafers auf dem ersten Silizium-Wafer mit einer Drehung um 45° bezogen auf den ersten Silizium-Wafer, so dass die beiden Teile (Cop1, Cop2) der thermischen Kompensationsschicht (Co1) Kontakt miteinander haben,
- Supprimieren (37) eines Substrats (Su2) und einer Isolierschicht (Ci2) vom zweiten Silizium-Wafer auf Isolierung (SOI), und
- Supprimieren (38) eines Substrats (Su1) und einer Isolierschicht (Ci1) vom zweiten Silizium-Wafer vom Typ Silicon-on-Insulator (SOI),
- der erste und der zweite Silizium-Wafer vom Typ Silicon-on-Insulator (SOI) bestehen aus einem Substrat (Su1, Su2) über dem sich eine Isolierschicht (Ci1, Ci2) befindet, dann eine der genannten ersten oder zweiten monokristalline n Siliziumschichten (Cs1, Cs2).

10. Verfahren zur Herstellung eines mechanischen Oszillators gemäß Anspruch 7, **dadurch gekennzeichnet, dass** es die folgenden Schritte umfasst:

- Gravieren (41) des Musters des mechanischen Oszillators auf einer ersten Siliziumschicht (Cs1), einer zweiten Isolierschicht (Ci2) und einer zweiten monokristalline n Siliziumschicht (Cs2) eines Silizium-Wafers vom Typ Doppel-Silicon-on-Insulator (Doppel-SOI), und
- Supprimieren (42) eines Substrats (Su1) und einer ersten Isolierschicht (Ci1) vom Silizium-Wafer,
- der erste Silizium-Wafer vom Typ Doppel-Silicon-on-Insulator (Doppel-SOI) besteht aus einem Substrat (Su1), über dem sich eine erste Isolierschicht (Ci1) befindet, eine erste monokristalline Siliziumschicht (Cs1), eine zweite Isolierschicht (Ci2) und schließlich eine zweite monokristalline Siliziumschicht (Cs2), die erste und die zweite monokristalline Siliziumschicht (Cs1, Cs2) des Silizium-Wafers Typ Doppel-Silicon-on-Insulator (Doppel-SOI) enthalten Kristallgitter, deren Richtungen um einen Winkel von 45° versetzt sind.

11. Verfahren zur Herstellung eines mechanischen Oszillators gemäß Anspruch 7, **dadurch gekennzeichnet, dass** es die folgenden Schritte umfasst:

- Gravieren (51) des Musters des mechanischen Oszillators auf einer zweiten Siliziumschicht (Cs2) und zweiten Isolierschicht (Ci2) eines ersten Silizium-Wafers vom Typ Doppel-Silicon-on-Insulator (Doppel-SOI),
- dichte Verbindung (52) eines zweiten Silizium-Wafers (Si2) auf der zweiten Siliziumschicht (Cs2) des ersten Silizium-Wafers,
- Supprimieren (53) eines Substrats (Su1) und einer erstem Isolierschicht (Ci1) vom ersten Silizium-Wafer,
- Gravieren (54) des Musters des mechanischen Oszillators auf einer ersten Siliziumschicht (Cs1) des ersten Silizium-Wafers, und
- Supprimieren (55) des zweiten Silizium-Wafers (Si2),
- der erste Silizium-Wafer vom Typ Doppel-Silicon-on-Insulator (Doppel-SOI) besteht aus einem Substrat (Su1) über dem sich eine erste Isolierschicht (Ci1) befindet, eine erste monokristalline Siliziumschicht (Cs1), eine zweite Isolierschicht (Ci2) und schließlich eine zweite monokristalline Siliziumschicht (Cs2), die erste und die zweite monokristalline Siliziumschicht (Cs1, Cs2) des Silizium-Wafers Typ Doppel-Silicon-on-Insulator (Doppel-SOI) enthalten Kristallgitter, deren Richtungen um einen Winkel von 45° versetzt sind.
- der zweite Silizium-Wafer (Si2) besteht aus einer einzigen Siliziumschicht über der sich eine Isolierschicht befinden kann oder nicht.

12. Verfahren zur Herstellung eines mechanischen Oszillators gemäß Anspruch 7, **dadurch gekennzeichnet, dass** es die folgenden Schritte umfasst:

- Ablagerung (61) einer thermischen Kompensationsschicht (Co1) auf einer Siliziumschicht (Cs1) eines ersten Silicon-on-Insulator-Wafers(SOI),
- Gravieren (62) des Musters des mechanischen Oszillators auf der thermischen Kompensationsschicht (Co1) und auf der ersten Siliziumschicht (Cs1) des ersten Silizium-Wafers,
- dichte Verbindung (63) eines zweiten Silizium-Wafers (Si2), unter Einbeziehung dieser zweiten Siliziumschicht (Cs2) auf dem ersten Silizium-Wafer, mit einer Drehung von 45° bezogen auf den ersten Silizium-Wafer, so dass der zweite Silizium-Wafer (Si2) Kontakt mit der thermischen Kompensationsschicht (Co1) hat
- Abtragen (64) des zweiten Silizium-Wafers (Si2),
- Gravieren (65) des Musters des mechanischen Oszillators auf der zweiten Siliziumschicht (Si2), und
- Supprimieren (66) eines Substrats (Su1) und einer Isolierschicht (Ci1) vom ersten Silizium-Wafer,
- der erste Silizium-Wafer vom Typ Silicon-on-Insulator (SOI) besteht aus einem Substrat (Su1) über dem sich eine Isolierschicht (Ci1) befindet, dann eine erste monokristalline Siliziumschicht (Cs1).
- der zweite Silizium-Wafer (Si2) besteht aus einer einzigen Schicht Silizium, über der sich eine Isolierschicht befinden kann oder nicht.

13. Verfahren zur Herstellung eines mechanischen Oszillators gemäß Anspruch 7, **dadurch gekennzeichnet, dass** es die folgenden Schritte umfasst:

- Abtragen (71) eines Substrats (Su1), das diese zweite Siliziumschicht (Cs2) eines Silizium-Wafers vom Typ Silicon-on-Insulator (SOI) bildet,
- Gravieren (72) des Musters des mechanischen Oszillators auf einer Siliziumschicht (Cs1) des Silizium-Wafers,
- Ablagern (73) einer Strukturschicht (Cst) auf dem Substrat (Su1) des Silizium-Wafers,
- Gravieren (74) des Musters des mechanischen Oszillators auf einem Substrat (Su1) und einer Isolierschicht (Ci1) des Silizium-Wafers, unter Verwendung der ersten Siliziumschicht als Maske, und
- Supprimieren (75) der Strukturschicht (Cst) vom Substrat (Su1) des Silizium-Wafers,
- der Silizium-Wafer vom Typ Silicon-on-Insulator (SOI) besteht aus einem Substrat (Su1) aus Silizium, über dem sich eine Isolierschicht (Ci1) befindet, dann eine monokristalline Siliziumschicht (Cs1), die erste Siliziumschicht (Cs1) und das Substrat (Su1) aus Silizium, des Silizium-Wafers vom Typ Silicon-on-Insulator (SOI) enthalten Kristallgitter, deren Richtungen um einen Winkel von 45° versetzt sind.

14. Verfahren zur Herstellung eines mechanischen Oszillators gemäß einem der Ansprüche 8 bis 13, **dadurch gekennzeichnet, dass** er einen zusätzlichen Schritt der Oxydation des Streifens umfasst.

15. Verfahren zur Herstellung eines Kohlenstoffsubstrats gemäß einem der Ansprüche 8 bis 14, **dadurch gekenn-**

**zeichnet, dass** es einen zusätzlichen Schritt umfasst, der darin besteht, eine zweite thermische Kompensationsschicht (Co2) und eine dritte Siliziumschicht (Cs3) aufzubringen.

**Claims**

1. A mechanical oscillator endowed with a rod (11), with the said rod (11) incorporating:

   - a first silicon layer (Cs1) having a crystal lattice extending along a first direction (Ds1) of a plane; and
   - a thermal compensation layer (Co1) made of a material having a thermal coefficient of the Young's modulus of opposite sign to that of the silicon;

   **characterized by** the fact that the said rod (11) also incorporates a second silicon layer (Cs2) having a crystal lattice extending along a second direction (Ds2) of the plane;

   - the first (Ds1) and the second (Ds2) direction being offset by an angle of 45° within the plane of the layers; and
   - the thermal compensation layer (Co1) extending between the first and second silicon layers (Cs1, Cs2).

2. Mechanical oscillator according to claim 1, **characterized by** the fact that the said rod (11) incorporates:

   - a third silicon layer (Cs3) incorporating a crystal lattice extending in a third direction (Ds3) parallel to the direction of the first silicon layer (Ds1); and
   - a second thermal compensation layer (Co2) made of a material having a thermal coefficient of the Young's modulus of opposite sign to that of the silicon;
   - with each thermal compensation layer (Co1, Co2) being located between two superposed silicon layers (Cs1, Cs2, Cs3);
   - with the direction of the second silicon layer (Cs2) located between the two other silicon layers (Cs1, Cs3) being offset by an angle of 45° in relation to the direction of the other two silicon layers (Cs1, Cs3).

3. Mechanical oscillator according to claim 1 or claim 2, **characterized by** the fact that the said rod (11) incorporates an outer thermal compensation layer (Coe) made of a material having a Young's modulus thermal coefficient of opposite sign to that of the silicon.

4. Mechanical oscillator according to one of claims 1 to 3, **characterized by** the fact that the thermal compensation layer (Co1, Co2, Coe), of which the material has a thermal coefficient of the Young's modulus of opposite sign to that of the silicon, is manufactured in Silicon oxide (SiO2).

5. Mechanical oscillator according to one of claims 1 to 4, **characterized by** the fact that the volume ratio between the material having a Young's modulus thermal coefficient of opposite sign to that of the silicon and the silicon layers (Cs1, Cs2, Cs3) is between 20% and 30% - preferably around 26% - at an ambient temperature of approximately 20°C.

6. Mechanical oscillator according to one of claims 1 to 5, **characterized by** the fact that the mechanical oscillator is a hairspring designed to equip the balance wheel of a mechanical clockwork assembly and formed from a spiral rod (11).

7. Method for manufacturing a mechanical oscillator in accordance with one of claims 1 to 6, **characterized by** the fact that it incorporates:

   - the etching a pattern of the mechanical oscillator onto the first silicon layer (Cs1) and onto the thermal compensation layer (Co1) and the second silicon layer (Cs2).

8. Process for manufacturing a mechanical oscillator in accordance with claim 7, **characterized by** the fact that it includes the following steps:

   - deposit (21) a thermal compensation layer (Co1) on a first silicon layer (Cs1) of a first silicon-on-insulator (SOI) wafer;
   - etch (22) the pattern of the mechanical oscillator onto the thermal compensation layer (Co1) and onto the first silicon layer (Cs1) of the first silicon-on-insulator (SOI) wafer;

- seal (23) a second silicon-on-insulator (SOI) wafer onto the first silicon wafer, with a rotation of 45° in relation to the first silicon wafer, such that a second silicon layer (Cs2) of the second silicon wafer is in contact with the thermal compensation layer (Co1);
- remove (24) a substrate (Su1) and an insulator layer (Ci1) of the first silicon-on-insulator (SOI) wafer;
- etch (25) the second silicon layer (Cs2) of the second silicon wafer, using the first silicon layer (Cs1) as a mask; and
- remove (26) a substrate (Su2) and an insulator layer (Ci2) of the second silicon-on-insulator (SOI) wafer;
- the first and second silicon-on-insulator (SOI) silicon wafer consisting of a substrate (Su1, Su2) topped by an insulator layer (Ci1, Ci2) followed by one of the aforesaid first or second monocrystalline silicon layers (Cs1, Cs2).

9. Process for manufacturing a mechanical oscillator in accordance with claim 7, **characterized by** the fact that it includes the following steps:

- deposit (32) a first part (Cop1) of a thermal compensation layer (Co1) onto a first silicon layer (Cs1) of a first silicon-on-insulator (SOI) wafer;
- deposit (33) a second part (Cop2) of the thermal compensation layer (Co1) onto a second silicon layer (Cs2) of a second silicon-on-insulator (SOI) wafer;
- etch (34) the pattern of the mechanical oscillator onto the first part (Cop1) of the thermal compensation layer (Co1), and onto the first silicon layer (Cs1) of the first silicon-on-insulator (SOI) wafer;
- etch the mechanical oscillator pattern onto the second part (Cop2) of the thermal compensation layer (Co1), and onto the second silicon layer (Cs2) of the second silicon-on-insulator (SOI) wafer;
- seal (36) the second silicon wafer onto the first silicon wafer, with a rotation of 45° in relation to the first silicon wafer, such that the two parts (Cop1, Cop2) of the thermal compensation layer (Co1) are in contact;
- remove (37) a substrate (Su2) and an insulator layer (Ci2) of the second silicon-on-insulator (SOI) wafer; and
- remove (38) a substrate (Su1) and an insulator layer (Ci1) of the first silicon-on-insulator (SOI) wafer;
- the first and second silicon-on-insulator (SOI) wafers consisting of a substrate (Su1, Su2) topped by an insulator layer (Ci1, Ci2) followed by one of the aforesaid first or second monocrystalline silicon layers (Cs1, Cs2).

10. Process for manufacturing a mechanical oscillator in accordance with claim 7, **characterized by** the fact that it includes the following steps:

- etch (41) the pattern of the mechanical oscillator onto a first silicon layer (Cs1), a second insulator layer (C2) and a second silicon layer (Cs2) of a silicon wafer of dual silicon-on-insulator type (dual-SOI); and
- remove (42) a substrate (Su1) and a first insulator layer (Ci1) of the silicon wafer;
- with the first silicon-on-insulator (dual-SOI) wafer consisting of a substrate (Su1) topped by a first insulator layer (C1), a first monocrystalline silicon layer (Cs1) of a second insulating layer (Ci2) followed by a second monocrystalline silicon layer (Cs2), with the first and second silicon layers (Cs1, Cs2) of the dual silicon-on-insulator (dual-SOI) wafer incorporating crystal lattices of which the directions are offset at an angle of 45°.

11. Process for manufacturing a mechanical oscillator in accordance with claim 7, **characterized by** the fact that it includes the following steps:

- etch (51) the pattern of the mechanical oscillator onto a second silicon layer (Cs2) and a second insulator layer (Ci2) of a first dual silicon-on-insulator (dual-SOI) wafer;
- seal (52) a second silicon wafer (Si2) onto the second silicon layer (Cs2) of the first silicon wafer;
- remove (53) a substrate (Su1) and a first insulator layer (Ci1) of the first silicon wafer;
- etch (54) the pattern of the mechanical oscillator onto a first silicon layer (Cs1) of the first silicon wafer; and
- remove (55) the second silicon wafer (Si2);
- with the first dual silicon-on-insulator (dual-SOI) wafer consisting of a substrate (Su1) topped by a first insulator layer (C1), a first monocrystalline silicon layer (Cs1), a second insulator layer (Ci2) followed by a second monocrystalline silicon layer (Cs2), with the first and second silicon layers (Cs1, Cs2) of the dual silicon-on-insulator (dual-SOI) wafer incorporating crystal lattices of which the directions are offset at an angle of 45°;
- with the second silicon wafer (Si2) comprising a single silicon layer that may or may not be topped by an insulating layer.

12. Process for manufacturing a mechanical oscillator in accordance with claim 7, **characterized by** the fact that it includes the following steps:

- deposit (61) a thermal compensation layer (Co1) on a silicon layer (Cs1) of a first silicon-on-insulator (SOI) wafer;
- etch (62) the pattern of the mechanical oscillator onto the thermal compensation layer (Co1) and onto the silicon layer (Cs1) of the first silicon wafer;
- seal (63) a second silicon wafer (Si2) incorporating the aforesaid second silicon layer (Cs2) onto the first silicon wafer, with a rotation of 45° in relation to the first silicon wafer, such that the second silicon wafer (Si2) is in contact with the thermal compensation layer (Co1);
- thin (64) the second silicon wafer (Si2);
- etch (65) the pattern of the mechanical oscillator onto the second silicon wafer (Si2); and
- remove (66) a substrate (Su1) and an insulator layer (Ci1) of the first silicon wafer;
- with the first silicon-on-insulator (SOI) wafer comprising a substrate (Su1) topped by an insulator layer (Ci1) followed by a monocrystalline silicon layer (Cs1);
- with the second silicon wafer (Si2) comprising a single silicon layer that may or may not be topped by an insulating layer.

13. Process for manufacturing a mechanical oscillator in accordance with claim 7, **characterized by** the fact that it includes the following steps:

- thin (71) a substrate (Su1) of a silicon-on-insulator (SOI) wafer to form the aforesaid second silicon layer (Cs2);
- etch (72) the pattern of the mechanical oscillator onto a silicon layer (Cs1) of the silicon wafer;
- deposit (73) a structuring layer (Cst) onto the aforesaid second silicon layer (Cs2);
- etch (74) the pattern of the mechanical oscillator onto the aforesaid second silicon layer (Cs2) and an insulator layer (Ci1) of the silicon wafer, using the first silicon layer as a mask; and
- remove (75) the structuring layer (Cst) from the aforesaid second silicon layer (Cs2);
- with the silicon-on-insulator (SOI) wafer comprising a silicon substrate (Su1) topped by an insulator layer (Ci1) followed by a monocrystalline silicon layer (Cs1), with the silicon layer (Cs1) and the silicon substrate (Su1) of the silicon-on-insulator (SOI) wafer having crystal lattices of which the directions are offset at a 45° angle.

14. Process for manufacturing a mechanical oscillator in accordance with one of claims 8 to 13, **characterized by** the fact that it incorporates an additional step of oxidation of the rod.

15. Process for manufacturing a mechanical oscillator in accordance with one of claims 8 to 14, **characterized by** the fact that it incorporates an additional step consisting in depositing a second thermal compensation layer (Co2) and a third silicon layer (Cs3).

Fig. 1

Fig. 2

## Cs1 (<100>)

Fig. 3

Fig. 4

Fig. 6

Fig. 7

Fig. 8

Fig. 9

Fig. 10

Fig. 11

Fig. 12

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CH 699780
- EP 1422436 A

- EP 2215531 A